# EUROPEAN PATENT APPLICATION

(11) **EP 4 779 444 A1**
(43) Date of publication of application: **22.07.2026**
(21) Application number: 25226357.9
(22) Date of filing: 22.12.2025
(51) Int. Cl.: G06F 3/046, G06F 1/16

(54) **DIGITIZER, DISPLAY DEVICE AND ELECTRONIC DEVICE**

(30) Priority: 17.01.2025 KR 20250007220
(71) Applicant: Samsung Display Co., Ltd., Yongin-si, Gyeonggi-do 17113 (KR)
(72) Inventor: JANG, Seokwon, Giheung-gu, Yongin-si, Gyeonggi-do 17113 (KR); NA, Hyunjae, Giheung-gu, Yongin-si, Gyeonggi-do 17113 (KR); LEE, Youngjin, Giheung-gu, Yongin-si, Gyeonggi-do 17113 (KR); CHO, Sunhaeng, Giheung-gu, Yongin-si, Gyeonggi-do 17113 (KR)
(74) Representative: Dr. Weitzel & Partner

(57) **Abstract**

A digitizer includes a base layer including a folding portion in which through-holes are defined and a non-folding portion adjacent to the folding portion in a first direction, and sensing coils disposed on the base layer. Each of the through-holes is defined as a first hole extending in a second direction intersecting the first direction, a second hole defined at a first end of the first hole, and a third hole defined at a second end of the first hole opposite to the first end. A first width of the first hole in the first direction is smaller than a second width of each of the second hole and the third hole in the first direction.

## Description

The present invention relates to a digitizer. More specifically, the present invention relates to a digitizer, a display device including the digitizer, and an electronic device including the digitizer.

A display device is a device that displays an image to provide visual information to a user. Recently, a flexible display device that can be transformed into various forms has been developed. Unlike a flat panel display device, the flexible display device can be folded, bent, or rolled like paper. The flexible display device is easy to carry and can improve user convenience.

In addition, the display device may include a digitizer that senses an input applied from outside. For example, the digitizer may be driven by electromagnetic resonance (EMR). The digitizer may include various sensing coils to be activated by an electrical signal.

The invention is defined by the features of claim 1. The dependent claims and the description provide preferred embodiments.

Embodiments provide a digitizer with improved efficiency in a manufacturing process.

Embodiments provide a display device including the digitizer.

Embodiments provide an electronic device including the digitizer.

A digitizer according to the present invention includes a base layer including a folding portion in which through-holes are defined and a non-folding portion adjacent to the folding portion in a first direction, and sensing coils disposed on the base layer. Each of the through-holes is defined as a first hole extending in a second direction intersecting the first direction, a second hole defined at a first end of the first hole, and a third hole defined at a second end of the first hole opposite to the first end, and a first width of the first hole in the first direction is smaller than a second width of each of the second hole and the third hole in the first direction. Thus, each of the first hole, the second hole and the third hole forms a part of a through hole, that is, the first hole, the second hole and the third hole merge to define the through hole. The form of the through hole may also be termed as a bone-shape.

In an embodiment, each of the second hole and the third hole may have a circular planar shape.

In an embodiment, each of the second hole and the third hole may have a water-droplet planar shape.

In an embodiment, each of the second hole and the third hole may have a polygonal planar shape.

In an embodiment, the second hole and the third hole may have a same planar shape.

In an embodiment, the base layer may include a polyimide film.

In an embodiment, the first width of the first hole in the first direction may be greater than 0 millimeter (mm) and less than or equal to 0.15 mm.

In an embodiment, the second width of each of the second hole and the third hole in the first direction may be greater than 0 mm and less than or equal to 0.9 mm.

In an embodiment, a separation distance between through-holes adjacent to each other in the first direction among the through-holes may be 0.1 mm to 1 mm. The separation distance may be defined as the distance in the first direction between the first holes of adjacent through holes.

In an embodiment, a length of each of the through-holes in the second direction may be 5 mm to 14 mm.

A display device according to an embodiment of the present invention includes a display panel, and a digitizer disposed below the display panel and including a base layer including a folding portion in which through-holes are defined and a non-folding portion adjacent to the folding portion in a first direction, and sensing coils disposed on the base layer. Each of the through-holes is defined as a first hole extending in a second direction intersecting the first direction, a second hole defined at a first end of the first hole, and a third hole defined at a second end of the first hole opposite to the first end, and a first width of the first hole in the first direction is smaller than a second width of each of the second hole and the third hole in the first direction. Thus, each of the first hole, the second hole and the third hole forms a part of a through hole, that is, the first hole, the second hole and the third hole merge to define the through hole. The form of the through hole may also be termed as a bone-shape.

In an embodiment, each of the second hole and the third hole may have a circular planar shape.

In an embodiment, each of the second hole and the third hole may have a water-droplet planar shape.

In an embodiment, each of the second hole and the third hole may have a polygonal planar shape.

In an embodiment, the second hole and the third hole may have a same planar shape.

In an embodiment, the first width of the first hole in the first direction may be greater than 0 mm and less than or equal to 0.15 mm.

In an embodiment, the second width of each of the second hole and the third hole in the first direction may be greater than 0 mm and less than or equal to 0.9 mm.

In an embodiment, a separation distance between through-holes adjacent to each other in the first direction among the through-holes may be 0.1 mm to 1 mm. The separation distance may be defined as the distance in the first direction between the first holes of adjacent through holes.

In an embodiment, a length of each of the through-holes in the second direction may be 5 mm to 14 mm.

An electronic device according to an embodiment of the present invention includes a display device, and a power module that supplies power to the display device. The display device includes a display panel, and a digitizer disposed below the display panel and including a base layer including a folding portion in which through-holes are defined and a non-folding portion adjacent to the folding portion in a first direction, and sensing coils disposed on the base layer. Each of the through-holes is defined as a first hole extending in a second direction intersecting the first direction, a second hole defined at a first end of the first hole, and a third hole defined at a second end of the first hole opposite to the first end, and a first width of the first hole in the first direction is smaller than a second width of each of the second hole and the third hole in the first direction. Thus, again, each of the first hole, the second hole and the third hole forms a part of a through hole, that is, the first hole, the second hole and the third hole merge to define the through hole. The form of the through hole may also be termed as a bone-shape.

In a digitizer according to embodiments of the present invention, the digitizer may include a folding portion in which through-holes are defined and sensing coils extending along edges of the through-holes. Each of the through-holes may be defined as a first hole, a second hole defined at a first end of the first hole, and a third hole defined at a second end of the first hole, and a width of the first hole in one direction may be smaller than a width of each of the second and third holes in the one direction. Accordingly, the digitizer may be easily folded when a display device is folded. In addition, a shape of the through-holes may be easily processed by a laser. Accordingly, a processing time of the through-holes may be shortened, and efficiency of a manufacturing process of the digitizer may be effectively improved.

FIG. 1 is a perspective view illustrating a display device according to an embodiment of the present invention in an unfolded state.

FIGS. 2 and 3 are perspective views illustrating the display device of FIG. 1 in a folded state.

FIG. 4 is an exploded perspective view illustrating the display device of FIG. 1.

FIG. 5 is a cross-sectional view illustrating the display device of FIG. 1.

FIG. 6 is a cross-sectional view illustrating a display panel included in the display device of FIG. 1.

FIGS. 7 and 8 are plan views illustrating a digitizer according to an embodiment of the present invention.

FIG. 9 is an enlarged plan view of area A of FIG. 7.

FIG. 10 is a plan view illustrating a digitizer according to an embodiment of the present invention.

FIG. 11 is a plan view illustrating a digitizer according to an embodiment of the present invention.

FIG. 12 is a plan view illustrating a digitizer according to an embodiment of the present invention.

FIG. 13 is a block diagram illustrating an electronic device according to an embodiment of the present invention.

FIG. 14 is a schematic diagram illustrating electronic devices according to various embodiments of the present invention.

It will be understood that when an element is referred to as being "on" another element, it can be directly on the other element or intervening elements may be present therebetween. In contrast, when an element is referred to as being "directly on" another element, there are no intervening elements present.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Hereinafter, embodiments of the present invention will be described in more detail with reference to the accompanying drawings. The same reference numerals are used for the same components in the drawings, and redundant descriptions of the same components will be omitted.

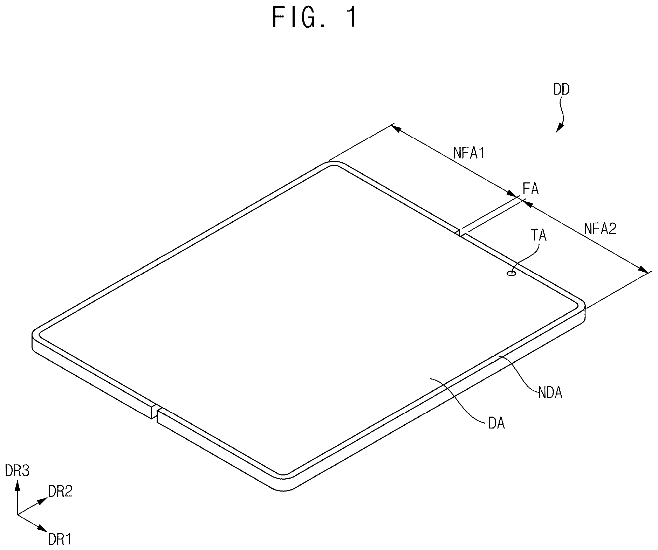

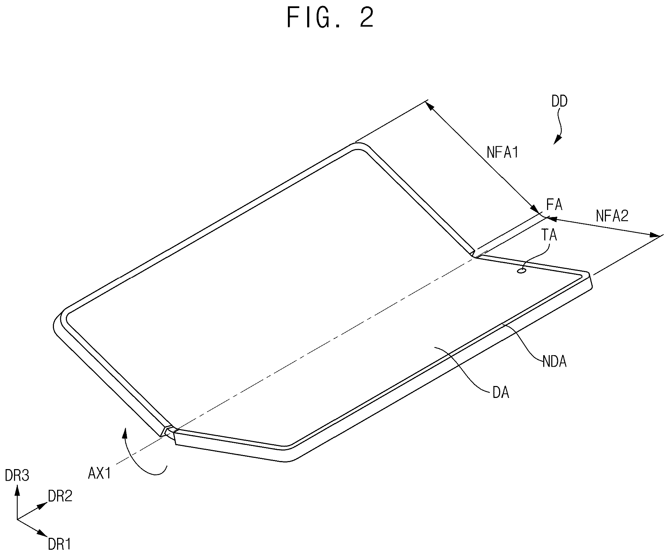

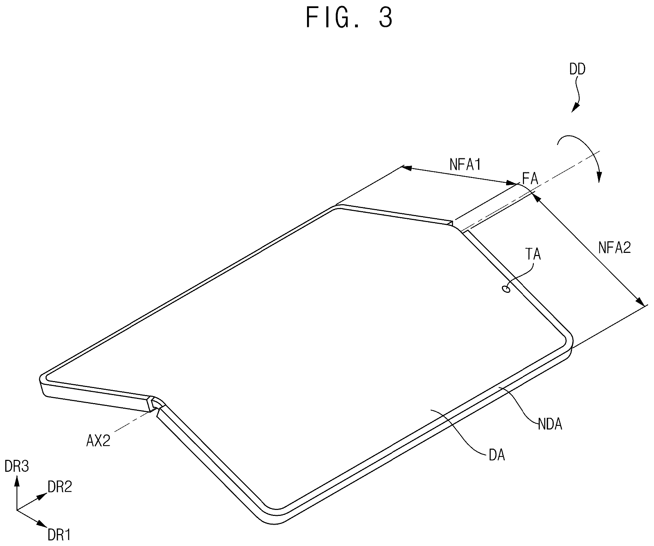

FIG. 1 is a perspective view illustrating a display device according to an embodiment of the present invention in an unfolded state. FIGS. 2 and 3 are perspective views illustrating the display device of FIG. 1 in a folded state. For example, FIG. 2 may be a perspective view illustrating the display device of FIG. 1 in an in-folded state, and FIG. 3 may be a perspective view illustrating the display device of FIG. 1 in an out-folded state.

In the present invention, a plane may be defined by a first direction DR1 and a second direction DR2 intersecting the first direction DR1. For example, the first direction DR1 and the second direction DR2 may be perpendicular to each other. A normal direction of the plane, that is, a thickness direction of the display device DD may be a third direction DR3. In other words, the third direction DR3 may be perpendicular to each of the first and second directions DR1 and DR2.

Referring to FIGS. 1, 2, and 3, the display device DD may include a display area DA, a transmissive area TA, and a non-display area NDA.

The display area DA may be an area that generates light to display an image. A plurality of pixels may be disposed in the display area DA. For example, the pixels may be disposed in a matrix form along the first direction DR1 and the second direction DR2. Each of the pixels may generate light according to a driving signal. Accordingly, an image may be displayed in the display area DA. For example, an image may be displayed in the third direction DR3 in the display area DA.

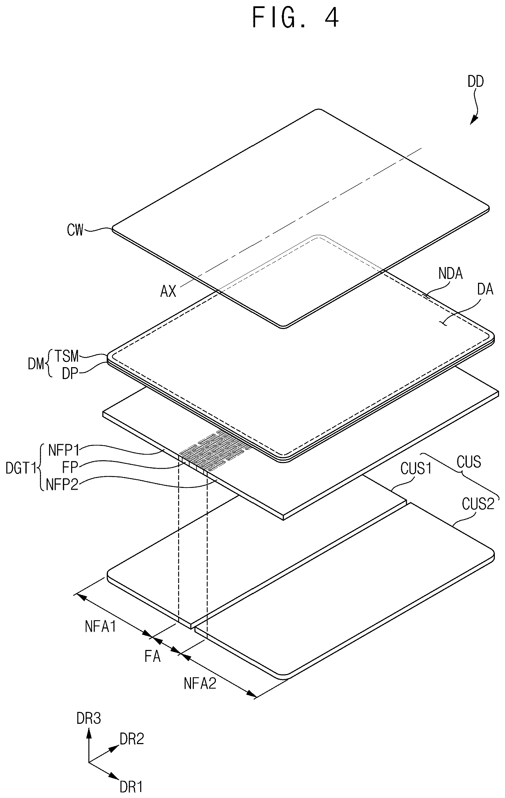

The non-display area NDA may be an area that does not display an image. The non-display area NDA may be located around the display area DA. The non-display area NDA may surround at least a portion of the display area DA in a plan view. However, the present invention is not limited thereto, and an image may be displayed in at least a portion of the non-display area NDA. For example, a pixel that generates light may be disposed in at least a portion of the non-display area NDA. As used herein, the "plan view" is a view in a thickness direction (i.e., third direction DR3) of the display device or a digitizer (See FIG. 4).

The transmissive area TA may have a higher transmittance than the display area DA and the non-display area NDA. The display device DD may further include a sensor that captures an external image using visible light passing through the transmissive area TA and determines accessibility of an external object using infrared light passing through the transmissive area TA. The sensor may overlap the transmissive area TA in a plan view. For example, the transmissive area TA may be located in the display area DA. However, the present invention is not limited thereto, and the transmissive area TA may be located in the non-display area NDA, or may be surrounded by the display area DA and the non-display area NDA in a plan view.

As illustrated in FIG. 2, the display device DD may be a foldable display device. For example, the display device DD may be folded along a virtual first folding axis AX1 extending in the second direction DR2.

The display device DD may include a folding area FA and a non-folding area. The folding area FA may be an area in which the display device DD is bent or folded. The folding area FA may be bent or folded by the first folding axis AX1. The non-folding area may be an area in which the display device DD is not bent or folded. The non-folding area may include a first non-folding area NFA1 and a second non-folding area NFA2 spaced apart from each other. The folding area FA may be located between the first non-folding area NFA1 and the second non-folding area NFA2. For example, the first non-folding area NFA1 may be adjacent to the folding area FA in a direction opposite to the first direction DR1, and the second non-folding area NFA2 may be adjacent to the folding area FA in the first direction DR1.

The display device DD may be folded in an in-folded state with respect to the first folding axis AX1. Here, the in-folded state may refer to a state in which the display area DA is folded inward.

However, the present invention is not limited thereto, and as illustrated in FIG. 3, the display device DD may be folded along a virtual second folding axis AX2 extending in the second direction DR2. In this case, the display device DD may be folded in an out-folded state with respect to the second folding axis AX2. Here, the out-folded state may refer to a state in which the display area DA is folded outward.

For example, the display device DD may be operated in the in-folded state or the out-folded state with respect to one folding axis.

Although FIGS. 1, 2, and 3 illustrate that the display device DD includes one folding area FA, the present invention is not limited thereto. For example, the display device DD may include a plurality of folding areas, or may implement a rollable display device.

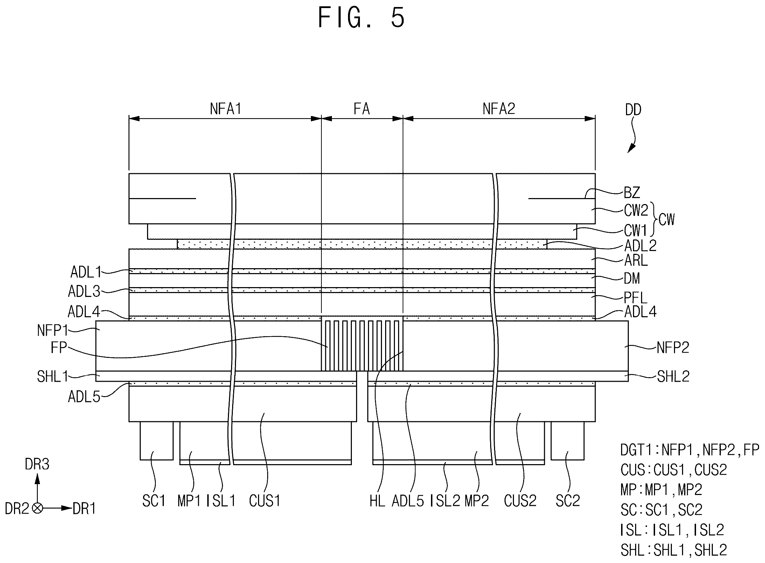

FIG. 4 is an exploded perspective view illustrating the display device of FIG. 1. FIG. 5 is a cross-sectional view illustrating the display device of FIG. 1.

Referring to FIGS. 4 and 5, the display device DD may include a display module DM, upper functional layers disposed on the display module DM, and lower functional layers disposed below the display module DM. For example, the upper functional layers may include an anti-reflection layer ARL and a cover window CW. For example, the lower functional layers may include a protective layer PFL, a digitizer DGT1, a shielding layer SHL, a cushion layer CUS, a metal plate MP, a step compensation member SC, and a lower insulating layer ISL.

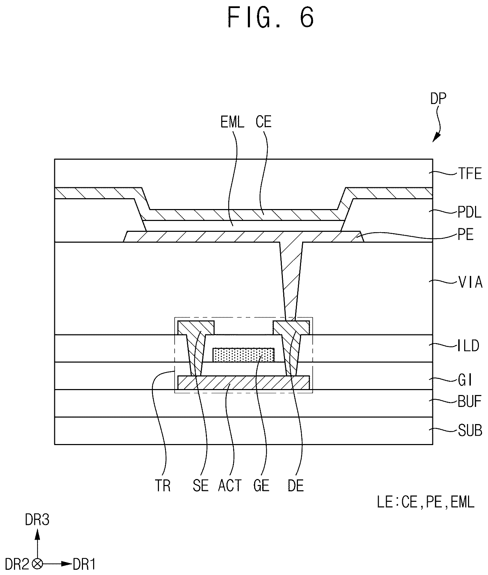

The display module DM may include a display panel DP and a touch member TSM. The display panel DP may include the pixels that generate and emit light. A cross-sectional structure of the display panel DP will be described later in more detail with reference to FIG. 6.

The touch member TSM may be disposed on the display panel DP. For example, the touch member TSM may be directly disposed on the display panel DP without a separate adhesive member. For another example, the touch member TSM may be attached to an upper surface of the display panel DP through an adhesive member.

The touch member TSM may detect a user's touch. For example, the touch member TSM may obtain coordinate information according to an external input such as a user's touch. For example, the touch member TSM may obtain coordinate information according to an external input using a mutual capacitance method and/or a self-capacitance method. The touch member TSM may include touch electrodes, connection lines connected to corresponding touch electrodes, and at least one touch insulating layer.

The anti-reflection layer ARL may be disposed on the touch member TSM. The anti-reflection layer ARL may be attached to an upper surface of the display module DM through a first adhesive layer ADL1. Specifically, the anti-reflection layer ARL may be attached to an upper surface of the touch member TSM through the first adhesive layer ADL1. The anti-reflection layer ARL may reduce reflection of external light of the display device DD. For example, the anti-reflection layer ARL may include a polarizer and/or a phase retarder. For example, the anti-reflection layer ARL may include color filters and a black matrix disposed between the color filters.

The first adhesive layer ADL1 may be disposed between the display module DM and the anti-reflection layer ARL. The first adhesive layer ADL1 may attach the display module DM and the anti-reflection layer ARL.

The cover window CW may be disposed on the anti-reflection layer ARL. The cover window CW may include a transparent material so that light provided from the display module DM may pass to outside. In an embodiment, the cover window CW may include a material having flexibility. Accordingly, the cover window CW may be folded with respect to a folding axis AX. The cover window CW may include a first cover layer CW1, a second cover layer CW2, and a bezel pattern BZ.

The first cover layer CW1 may be disposed on the anti-reflection layer ARL. The first cover layer CW1 may be attached to an upper surface of the anti-reflection layer ARL through a second adhesive layer ADL2. The first cover layer CW1 may include a thin film glass or a synthetic resin. For example, the synthetic resin may include polyimide (PI) or polyethylene terephthalate (PET).

The second adhesive layer ADL2 may be disposed between the anti-reflection layer ARL and the first cover layer CW1. The second adhesive layer ADL2 may attach the anti-reflection layer ARL and the first cover layer CW1.

The second cover layer CW2 may be disposed on the first cover layer CW1. The second cover layer CW2 may include a material having a relatively lower modulus than the first cover layer CW1. In addition, the second cover layer CW2 may have a relatively greater thickness (or length in the third direction DR3) than the first cover layer CW1. Accordingly, the second cover layer CW2 may protect the first cover layer CW1. For example, the second cover layer CW2 may have a multi-layer structure. For example, the second cover layer CW2 may include an anti-fingerprint layer.

The bezel pattern BZ may be disposed inside the second cover layer CW2. The bezel pattern BZ may be disposed at an edge of the second cover layer CW2. The bezel pattern BZ may include a light blocking material that blocks light. For example, the bezel pattern BZ may include an organic material, an inorganic material, or the like including a light blocking material having a black color.

The protective layer PFL may be disposed below the display module DM. The protective layer PFL may be attached to a lower surface of the display module DM through a third adhesive layer ADL3. The protective layer PFL may protect the display module DM from an external impact. The protective layer PFL may include an organic material having flexibility. For example, the protective layer PFL may include polyimide, polyethylene terephthalate, polyethylene naphthalate, or the like.

The third adhesive layer ADL3 may be disposed between the display module DM and the protective layer PFL. The third adhesive layer ADL3 may attach the display module DM and the protective layer PFL.

The digitizer DGT1 may be disposed below the protective layer PFL. The digitizer DGT1 may be attached to a lower surface of the protective layer PFL through a fourth adhesive layer ADL4. The digitizer DGT1 may detect an input by an electromagnetic pen. For example, the digitizer DGT1 may be driven using electromagnetic resonance (EMR).

The digitizer DGT1 may include a first non-folding portion NFP1, a second non-folding portion NFP2, and a folding portion FP. The first and second non-folding portions NFP1 and NFP2 may be portions in which the digitizer DGT1 is not bent or folded, and the folding portion FP may be a portion in which the digitizer DGT1 is bent or folded.

The first non-folding portion NFP1 may at least partially overlap the first non-folding area NFA1 in a plan view. The second non-folding portion NFP2 may at least partially overlap the second non-folding area NFA2 in a plan view. The folding portion FP may at least partially overlap the folding area FA in a plan view. The folding portion FP may be disposed between the first non-folding portion NFP1 and the second non-folding portion NFP2. For example, the first non-folding portion NFP1 may be adjacent to the folding portion FP in the direction opposite to the first direction DR1, and the second non-folding portion NFP2 may be adjacent to the folding portion FP in the first direction DR1.

A plurality of through-holes HL may be defined in the folding portion FP. The through-holes HL may penetrate the folding portion FP in the thickness direction (or the third direction DR3). In other words, the through-holes HL may communicate from an upper surface of the folding portion FP of the digitizer DGT1 to a lower surface of the folding portion FP of the digitizer DGT1. The inside of the through-holes HL may be empty spaces in which no other materials (e.g., resin) are disposed. The through-holes HL may be spaced apart from each other in the first direction DR1. In addition, the through-holes HL may be spaced apart from each other in the second direction DR2.

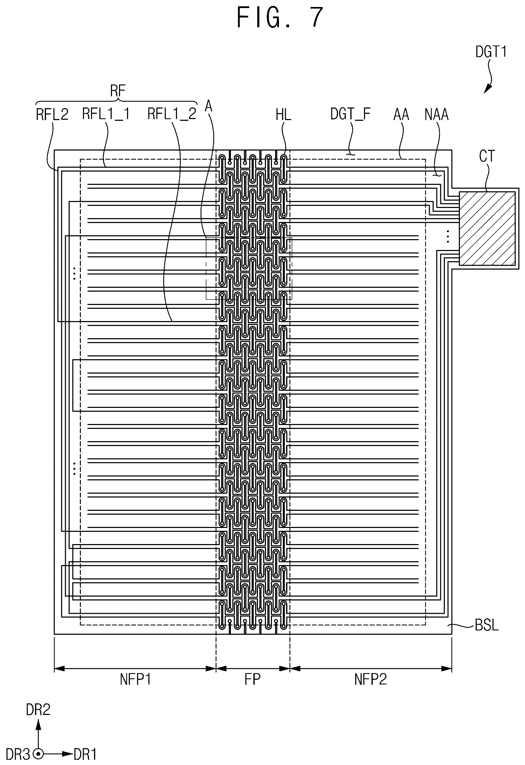

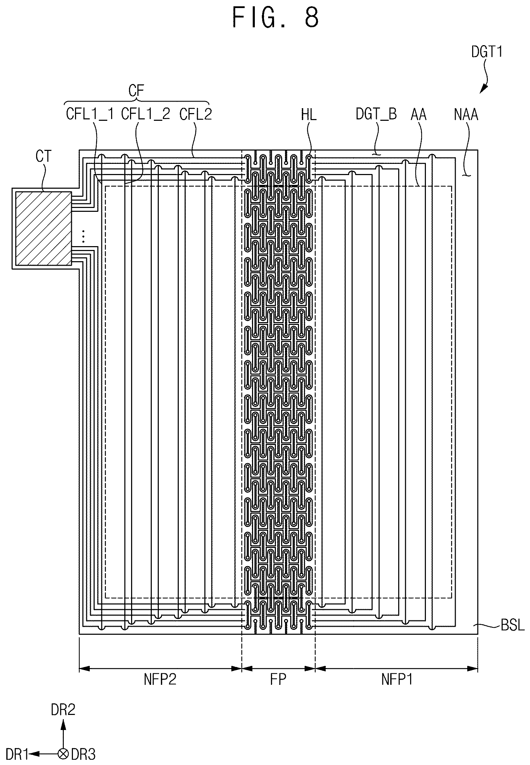

The digitizer DGT1 may further include sensing coils (e.g., a first sensing coil RF of FIG. 7 or a second sensing coil CF of FIG. 8) that bend and extend along at least a portion of edges of the through-holes HL in a plan view. A base layer (e.g., a base layer BSL of FIG. 7) on which the sensing coils are disposed may include a material having a relatively low dielectric constant. For example, the base layer may be a polyimide film, but the present invention is not limited thereto. For example, a thickness (i.e., a length in the third direction DR3) of the digitizer DGT1 may be about 400 micrometers (µm) or less.

As the digitizer DGT1 includes the folding portion FP corresponding to the folding area FA, when the display device DD is folded, the digitizer DGT1 may secure flexibility so that a shape thereof may be easily changed and may be easily folded.

The fourth adhesive layer ADL4 may be disposed between the protective layer PFL and the digitizer DGT1. Specifically, the fourth adhesive layer ADL4 may include a first portion and a second portion. The first portion of the fourth adhesive layer ADL4 may be spaced apart from the second portion of the fourth adhesive layer ADL4 in the first direction DR1 with the folding area FA interposed therebetween. The first portion of the fourth adhesive layer ADL4 may attach a portion of the protective layer PFL and the first non-folding portion NFP1. The second portion of the fourth adhesive layer ADL4 may attach another portion of the protective layer PFL and the second non-folding portion NFP2.

The shielding layer SHL may be disposed below the digitizer DGT1. For example, the shielding layer SHL may be disposed on a lower surface of the digitizer DGT1 without a separate adhesive member. For another example, the shielding layer SHL may be attached to the lower surface of the digitizer DGT1 through an adhesive member. The shielding layer SHL may shield electromagnetic interference noise. The shielding layer SHL may include a metal. For example, the shielding layer SHL may include magnetic metal powder. However, the present invention is not limited thereto, and the shielding layer SHL may include permalloy or invar which are alloys of nickel (Ni) and iron (Fe), stainless steel, or the like.

The shielding layer SHL may include a first shielding layer SHL1 and a second shielding layer SHL2. The first shielding layer SHL1 may be spaced apart from the second shielding layer SHL2 in the first direction DR1 in the folding area FA. The first shielding layer SHL1 may overlap a portion of the folding portion FP and the first non-folding portion NFP1 in a plan view. The second shielding layer SHL2 may overlap another portion of the folding portion FP and the second non-folding portion NFP2 in a plan view. However, the present invention is not limited thereto, and the shielding layer SHL may entirely overlap the folding area FA in a plan view, and may cover the through-holes HL.

The cushion layer CUS may be disposed below the shielding layer SHL. The cushion layer CUS may be attached to a lower surface of the shielding layer SHL through a fifth adhesive layer ADL5. The cushion layer CUS may protect the display module DM and the digitizer DGT1 from an external impact. In addition, the cushion layer CUS may prevent a foreign substance from entering the through-holes HL when the display device DD is unfolded. For example, the cushion layer CUS may include rubber, urethane-based material, acrylic-based material, foam tape, foam pad, or the like.

The cushion layer CUS may include a first cushion layer CUS1 and a second cushion layer CUS2. The first cushion layer CUS1 may be spaced apart from the second cushion layer CUS2 in the first direction DR1 in the folding area FA. The first cushion layer CUS1 may overlap the first shielding layer SHL1 in a plan view. In addition, the first cushion layer CUS1 may overlap a portion of the folding portion FP and the first non-folding portion NFP1 in a plan view. The second cushion layer CUS2 may overlap the second shielding layer SHL2 in a plan view. In addition, the second cushion layer CUS2 may overlap another portion of the folding portion FP and the second non-folding portion NFP2 in a plan view. As the first cushion layer CUS1 is spaced apart from the second cushion layer CUS2 in the first direction DR1 in the folding area FA, the shape of the digitizer DGT1 may be easily transformed when the folding portion FP is folded with a curvature.

The fifth adhesive layer ADL5 may be disposed between the shielding layer SHL and the cushion layer CUS. Specifically, the fifth adhesive layer ADL5 may include a first portion and a second portion. The first portion of the fifth adhesive layer ADL5 may be spaced apart from the second portion of the fifth adhesive layer ADL5 in the first direction DR1 in the folding area FA. The first portion of the fifth adhesive layer ADL5 may attach the first shielding layer SHL1 and the first cushion layer CUS1. The second portion of the fifth adhesive layer ADL5 may attach the second shielding layer SHL2 and the second cushion layer CUS2.

The metal plate MP, the step compensation member SC, and the lower insulating layer ISL may be disposed below the cushion layer CUS.

The metal plate MP may protect the display module DM from an external impact. For example, the metal plate MP may include stainless steel, but the present invention is not limited thereto. The metal plate MP may include a first metal layer MP1 and a second metal layer MP2. The first metal layer MP1 may contact the first cushion layer CUS1, and the second metal layer MP2 may contact the second cushion layer CUS2.

The step compensation member SC may include a double-sided tape or an insulating film. The step compensation member SC may include a first step compensation layer SC1 and a second step compensation layer SC2. The first step compensation layer SC1 may contact the first cushion layer CUS1, and may be adjacent to the first metal layer MP1. The second step compensation layer SC2 may contact the second cushion layer CUS2, and may be adjacent to the second metal layer MP2.

The lower insulating layer ISL may be disposed below the metal plate MP. The lower insulating layer ISL may block noise such as static electricity generated from the outside. The lower insulating layer ISL may include an inorganic insulating material and/or an organic insulating material. The lower insulating layer ISL may include a first lower insulating layer ISL1 and a second lower insulating layer ISL2. The first lower insulating layer ISL1 may contact the first metal layer MP1, and the second lower insulating layer ISL2 may contact the second metal layer MP2.

FIG. 6 is a cross-sectional view illustrating a display panel included in the display device of FIG. 1.

Referring to FIG. 6, the display panel DP may include a substrate SUB, a buffer layer BUF, a gate insulating layer GI, an interlayer insulating layer ILD, a via insulating layer VIA, an active layer ACT, a gate electrode GE, a source electrode SE, a drain electrode DE, a pixel electrode PE, a pixel defining layer PDL, a light emitting layer EML, a common electrode CE, and an encapsulation layer TFE.

A transistor TR may include the active layer ACT, the gate electrode GE, the source electrode SE, and the drain electrode DE. A light emitting element LE may include the pixel electrode PE, the light emitting layer EML, and the common electrode CE.

The substrate SUB may form a base of the display device DD. The substrate SUB may include a transparent material or an opaque material. For example, the substrate SUB may include glass, quartz, plastic, silicon, or the like. These may be used alone or in combination with each other.

The buffer layer BUF may be disposed on the substrate SUB. The buffer layer BUF may prevent metal atoms or impurities from diffusing from the substrate SUB to the transistor TR. In addition, the buffer layer BUF may improve flatness of a surface of the substrate SUB when the surface of the substrate SUB is not uniform. For example, the buffer layer BUF may include an inorganic insulating material such as silicon oxide (SiOₓ), silicon nitride (SiNₓ), silicon oxynitride (SiOₓN_{y}), or the like. These may be used alone or in combination with each other.

The active layer ACT may be disposed on the buffer layer BUF. The active layer ACT may include a source area, a drain area, and a channel area between the source area and the drain area. The source area and the drain area may have higher conductivity than the channel area. The active layer ACT may include an oxide semiconductor, a silicon semiconductor, or the like. For example, the oxide semiconductor may include at least one oxide selected from among indium (In), gallium (Ga), tin (Sn), zirconium (Zr), vanadium (V), hafnium (Hf), cadmium (Cd), germanium (Ge), chromium (Cr), titanium (Ti), and zinc (Zn). The silicon semiconductor may include amorphous silicon, polycrystalline silicon, or the like.

The gate insulating layer GI may be disposed on the buffer layer BUF, and may cover at least a portion of the active layer ACT. For example, the gate insulating layer GI may include an inorganic insulating material such as silicon oxide, silicon nitride, silicon oxynitride, or the like. These may be used alone or in combination with each other.

The gate electrode GE may be disposed on the gate insulating layer GI. The gate electrode GE may overlap the channel area of the active layer ACT in a plan view. For example, the gate electrode GE may include a conductive material such as a metal, an alloy, a conductive metal nitride, a conductive metal oxide, a transparent conductive material, or the like. For example, the gate electrode GE may include gold (Au), silver (Ag), aluminum (Al), platinum (Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), scandium (Sc), neodymium (Nd), iridium (Ir), an alloy containing aluminum, an alloy containing silver, an alloy containing copper, an alloy containing molybdenum, aluminum nitride (AlNₓ), tungsten nitride (WNₓ), titanium nitride (TiNₓ), chromium nitride (TiNₓ), tantalum nitride (TaNₓ), zinc oxide (ZnOₓ), indium tin oxide (ITO), tin oxide (SnOₓ), indium oxide (InOₓ), gallium oxide (GaOₓ), indium zinc oxide (IZO), or the like. These may be used alone or in combination with each other.

The interlayer insulating layer ILD may be disposed on the gate insulating layer GI, and may cover the gate electrode GE. For example, the interlayer insulating layer ILD may include an inorganic insulating material such as silicon oxide, silicon nitride, silicon oxynitride, or the like. These may be used alone or in combination with each other.

The source electrode SE and the drain electrode DE may be disposed on the interlayer insulating layer ILD. The source electrode SE may be connected to the source area of the active layer ACT through a first contact hole penetrating a lower insulating layer (e.g., the gate insulating layer GI and the interlayer insulating layer ILD). The drain electrode DE may be connected to the drain area of the active layer ACT through a second contact hole penetrating a lower insulating layer (e.g., the gate insulating layer GI and the interlayer insulating layer ILD). For example, the source electrode SE and the drain electrode DE may include a conductive material such as a metal, an alloy, a conductive metal nitride, a conductive metal oxide, a transparent conductive material, or the like. These may be used alone or in combination with each other.

The via insulating layer VIA may be disposed on the interlayer insulating layer ILD, and may cover the source electrode SE and the drain electrode DE. For example, the via insulating layer VIA may include an organic insulating material such as a photoresist, an acrylic resin, a polyimide resin, a polyamide resin, a siloxane resin, an epoxy resin, or the like. These may be used alone or in combination with each other.

The pixel electrode PE may be disposed on the via insulating layer VIA. The pixel electrode PE may be electrically connected to the transistor TR. For example, the pixel electrode PE may be contacted to the drain electrode DE (or the source electrode SE) through a contact hole penetrating a lower insulating layer (e.g., the via insulating layer VIA). For example, the pixel electrode PE may be a first terminal (e.g., an anode) of the light emitting element LE. For example, the pixel electrode PE may include a conductive material such as a metal, an alloy, a conductive metal nitride, a conductive metal oxide, a transparent conductive material, or the like. These may be used alone or in combination with each other.

The pixel defining layer PDL may be disposed on the pixel electrode PE, and may cover at least a portion of the pixel electrode PE. The pixel defining layer PDL may define an opening exposing at least a portion of the pixel electrode PE. For example, the pixel defining layer PDL may include an organic insulating material such as a photoresist, an acrylic resin, a polyimide resin, a polyamide resin, or the like and/or an inorganic insulating material such as silicon oxide, silicon nitride, silicon oxynitride, or the like. These may be used alone or in combination with each other.

The light emitting layer EML may be disposed on the pixel electrode PE. The light emitting layer EML may be disposed in the opening of the pixel defining layer PDL. The light emitting layer EML may include a light emitting material. For example, the light emitting layer EML may include at least one of an organic light emitting material and a quantum dot. The light emitting layer EML may further include a functional layer including at least one of a hole injection layer, a hole transport layer, an electron transport layer, and an electron injection layer.

The common electrode CE may be disposed on the light emitting layer EML. For example, the common electrode CE may be a second terminal (e.g., a cathode) of the light emitting element LE. For example, the common electrode CE may include a conductive material such as a metal, an alloy, a conductive metal nitride, a conductive metal oxide, a transparent conductive material, or the like. These may be used alone or in combination with each other.

The encapsulation layer TFE may be disposed on the common electrode CE. The encapsulation layer TFE may prevent impurities such as oxygen and moisture from penetrating into the light emitting element LE. The encapsulation layer TFE may include at least one inorganic layer and at least one organic layer.

FIGS. 7 and 8 are plan views illustrating a digitizer according to an embodiment of the present invention.

For example, FIG. 7 may be a plan view illustrating a front surface of the digitizer of FIGS. 4 and 5, and FIG. 8 may be a plan view illustrating a rear surface of the digitizer of FIGS. 4 and 5. For example, FIG. 7 may illustrate sensing coils disposed on a front surface DGT_F of the digitizer DGT1, and FIG. 8 may illustrate sensing coils disposed on a rear surface DGT_B of the digitizer DGT1.

Referring to FIGS. 7 and 8, the digitizer DGT1 may include an active area AA and a non-active area NAA.

The active area AA of the digitizer DGT1 may overlap the display area (e.g., the display area DA of FIG. 1) of the display device (e.g., the display device DD of FIG. 1) in a plan view. That is, the active area AA of the digitizer DGT1 may correspond to the display area of the display device. However, the present invention is not limited thereto, and the active area AA of the digitizer DGT1 may at least partially overlap the non-display area (e.g., the non-display area NDA of FIG. 1) of the display device in a plan view.

The non-active area NAA of the digitizer DGT1 may overlap the non-display area of the display device in a plan view. That is, the non-active area NAA of the digitizer DGT1 may correspond to the non-display area of the display device. However, the present invention is not limited thereto, and the non-active area NAA of the digitizer DGT1 may at least partially overlap the display area of the display device in a plan view.

For example, the active area AA may be defined as an area that senses an input of a pen. In addition, the non-active area NAA may be an area in which connection lines for each of the first sensing coils RF and the second sensing coils CF to form a loop are disposed. In the non-active area NAA, the connection lines for each of the first sensing coils RF and the second sensing coils CF to form a loop may be densely disposed.

The digitizer DGT1 may include a base layer BSL, the first sensing coils RF, the second sensing coils CF, and a connector CT.

The base layer BSL may form a base of the digitizer DGT1. In an embodiment, the base layer BSL may include a material having a relatively low dielectric constant. For example, the base layer BSL may include a polyimide film, but the present invention is not limited thereto.

The connector CT may be disposed in the non-active area NAA of the digitizer DGT1. For example, the connector CT may be disposed in the first non-folding portion NFP1 or the second non-folding portion NFP2.

In an embodiment, the first sensing coils RF may be disposed on the front surface DGT_F of the digitizer DGT1, and the second sensing coils CF may be disposed on the rear surface DGT_B of the digitizer DGT1. The first and second sensing coils RF and CF may be disposed on the base layer BSL. In an embodiment, the first and second sensing coils RF and CF may include a conductive material such as a metal, an alloy, a conductive metal nitride, a conductive metal oxide, a transparent conductive material, or the like.

The first sensing coils RF may include first extension lines RFL1_1, second extension lines RFL1_2, and first connection lines RFL2. Each of the first extension lines RFL1_1 and the second extension lines RFL1_2 may extend in the first direction DR1. For example, each of the first and second extension lines RFL1_1 and RFL1_2 may be disposed in the active area AA and the non-active area NAA. Each of the first connection lines RFL2 may extend in the second direction DR2. For example, each of the first connection lines RFL2 may be disposed in the non-active area NAA. Each of the first connection lines RFL2 may connect one end of each of the first extension lines RFL1_1 and one end of each of the second extension lines RFL1_2 to each other. Accordingly, the first sensing coils RF may form a plurality of loops.

In an embodiment, the plurality of loops formed by the first sensing coils RF may include a plurality of loops having different lengths in the second direction DR2. For example, the lengths of the first connection lines RFL2 forming the plurality of loops formed by the first sensing coils RF in the second direction DR2 may be different for each loop. That is, widths in the second direction DR2 between each of the first extension lines RFL1_1 and each of the second extension lines RFL1_2 may be different from each other. However, the present invention is not limited thereto, and in an embodiment, the plurality of loops formed by the first sensing coils RF may include a plurality of loops having substantially the same length in the second direction DR2. In this case, the lengths of the first connection lines RFL2 forming the plurality of loops formed by the first sensing coils RF in the second direction DR2 may be substantially the same.

The shapes of the plurality of loops formed by the first sensing coils RF may be variously changed depending on embodiments. For example, the shapes of the plurality of loops formed by the first sensing coils RF may have any shape extending in the first direction DR1.

The first and second extension lines RFL1_1 and RFL1_2 may be disposed in the first non-folding portion NFP1, the second non-folding portion NFP2, and the folding portion FP. The first connection lines RFL2 may be disposed in the first non-folding portion NFP1 or the second non-folding portion NFP2.

In an embodiment, a portion of the first extension lines RFL1_1 disposed in the folding portion FP of the digitizer DGT1 may be disposed between the through-holes HL. A portion of the first extension lines RFL1_1 disposed in the folding portion FP of the digitizer DGT1 may extend from the first non-folding portion NFP1 to the second non-folding portion NFP2 via the through-holes HL. In addition, a portion of the second extension lines RFL1_2 disposed in the folding portion FP of the digitizer DGT1 may be disposed between the through-holes HL. A portion of the second extension lines RFL1_2 disposed in the folding portion FP of the digitizer DGT1 may extend from the first non-folding portion NFP1 to the second non-folding portion NFP2 via the through-holes HL.

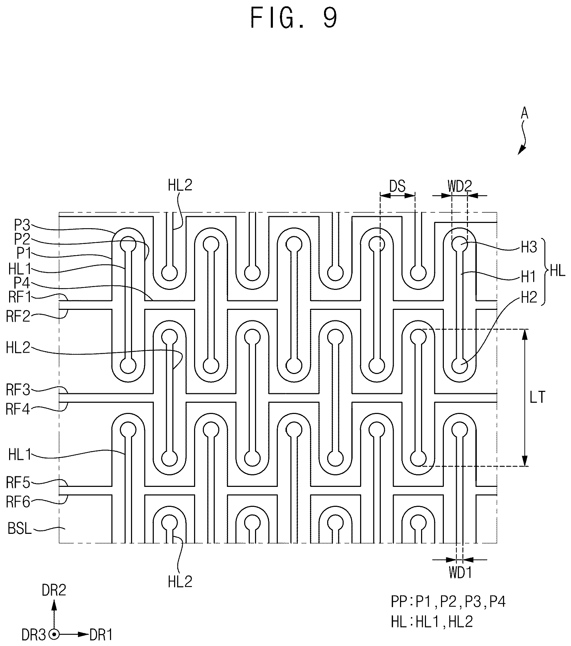

In an embodiment, each of the first and second extension lines RFL1_1 and RFL1_2 may be bent and extended along an edge of the through-holes HL in the folding portion FP. Accordingly, each of the first and second extension lines RFL1_1 and RFL1_2 may include a curved pattern having a curvature (e.g., a third pattern P3 of FIG. 9). A detailed description thereof will be described later with reference to FIG. 9.

Each of the first sensing coils RF may be connected to the connector CT. For example, one end of each of the first sensing coils RF may be connected to the connector CT in the non-active area NAA. For example, the first sensing coils RF may be connected to the connector CT through connector connection lines, respectively.

FIG. 7 illustrates an example in which the first sensing coils RF are disposed on the front surface DGT_F of the digitizer DGT1, but this is for convenience of description, and some of the first sensing coils RF may be disposed on the rear surface DGT_B of the digitizer DGT1.

The second sensing coils CF may include third extension lines CFL1_1, fourth extension lines CFL1_2, and second connection lines CFL2. Each of the third extension lines CFL1_1 and the fourth extension lines CFL1_2 may extend in the second direction DR2. For example, the third and fourth extension lines CFL1_1 and CFL1_2 may be disposed in the active area AA and the non-active area NAA. Each of the second connection lines CFL2 may extend in the first direction DR1. For example, the second connection lines CFL2 may be disposed in the non-active area NAA. Each of the second connection lines CFL2 may connect one end of each of the third extension lines CFL1_1 and one end of each of the fourth extension lines CFL1_2 to each other. Accordingly, the second sensing coils CF may form a plurality of loops.

In an embodiment, the plurality of loops formed by the second sensing coils CF may include a plurality of loops having different lengths in the first direction DR1. For example, the lengths of the second connection lines CFL2 forming the plurality of loops formed by the second sensing coils CF in the first direction DR1 may be different for each loop. That is, widths in the first direction DR1 between each of the third extension lines CFL1_1 and each of the fourth extension lines CFL1_2 may be different from each other. However, the present invention is not limited thereto, and in an embodiment, the plurality of loops formed by the second sensing coils CF may include a plurality of loops having substantially the same length in the first direction DR1. In this case, the lengths of the second connection lines CFL2 forming the plurality of loops formed by the second sensing coils CF in the first direction DR1 may be substantially the same.

The shapes of the plurality of loops formed by the second sensing coils CF may be variously changed depending on embodiments. For example, the shapes of the plurality of loops formed by the second sensing coils CF may have any shape extending in the second direction DR2.

The third and fourth extension lines CFL1_1 and CFL1_2 may be disposed in the first non-folding portion NFP1, the second non-folding portion NFP2, and the folding portion FP. The second connection lines CFL2 may be disposed in the first non-folding portion NFP1, the second non-folding portion NFP2, and the folding portion FP.

In an embodiment, a portion of the third extension lines CFL1_1 disposed in the folding portion FP of the digitizer DGT1 may be disposed between the through-holes HL. A portion of the third extension lines CFL1_1 disposed in the folding portion FP of the digitizer DGT1 may extend in the second direction DR2 via the through-holes HL. In addition, a portion of the fourth extension lines CFL1_2 disposed in the folding portion FP of the digitizer DGT1 may be disposed between the through-holes HL. A portion of the fourth extension lines CFL1_2 disposed in the folding portion FP of the digitizer DGT1 may extend in the second direction DR2 via the through-holes HL. In addition, a portion of the second connection lines CFL2 disposed in the folding portion FP of the digitizer DGT1 may be disposed between the through-holes HL. A portion of the second connection lines CFL2 disposed in the folding portion FP of the digitizer DGT1 may be connected to one end of the corresponding third extension lines CFL1_1 and one end of the corresponding fourth extension lines CFL1_2 via the through-holes HL.

Each of the second sensing coils CF may be connected to the connector CT. For example, one end of each of the second sensing coils CF may be connected to the connector CT in the non-active area NAA. For example, the second sensing coils CF may be connected to the connector CT through connector connection lines, respectively.

FIG. 8 illustrates an example in which the second sensing coils CF are disposed on the rear surface DGT_B of the digitizer DGT1, but this is for convenience of description, and some of the second sensing coils CF may be disposed on the front surface DGT_F of the digitizer DGT1.

For example, the first sensing coils RF may be defined as sensing coils, and the second sensing coils CF may be defined as driving coils. When current flows through the second sensing coils CF, a magnetic force line may be induced between the second sensing coils CF and the first sensing coils RF. The first sensing coils RF may sense an induced electromagnetic force emitted from the electromagnetic pen and output it to one terminal of each of the first sensing coils RF as a sensing signal. One terminal of each of the first sensing coils RF may be connected to signal lines disposed in the non-active area NAA. However, the present invention is not limited thereto, and the first sensing coils RF may be defined as driving coils, and the second sensing coils CF may be defined as sensing coils.

FIG. 9 is an enlarged plan view of area A of FIG. 7.

Referring to FIGS. 7 and 9, the through-holes HL may be defined in the folding portion FP of the digitizer DGT1. Each of the through-holes HL may penetrate the base layer BSL in the thickness direction (i.e., the third direction DR3). In an embodiment, the through-holes HL may be formed through laser processing. In other words, the through-holes HL may communicate from an upper surface of the folding portion FP of the digitizer DGT1 to a lower surface of the folding portion FP of the digitizer DGT1. The inside of the through-holes HL may be empty spaces in which no other materials (e.g., resin) are disposed.

Each of the through-holes HL may be defined as a first hole H1, a second hole H2, and a third hole H3 connected to each other. In an embodiment, the first hole H1 may extend in the second direction DR2, the second hole H2 may be defined at a first end of the first hole H1, and the third hole H3 may be defined at a second end facing (i.e., opposite to) the first end of the first hole H1. For example, the third hole H3 may be spaced apart from the second hole H2 in the second direction DR2, and the first hole H1 may connect the second hole H2 and the third hole H3 to each other. All the first to third holes H1 to H3 included in the through-hole HL may be also through-holes.

A planar shape of the first hole H1 may be different from a planar shape of each of the second hole H2 and the third hole H3. For example, a planar shape of the second hole H2 and a planar shape of the third hole H3 may be substantially the same as or similar to each other. In an embodiment, at least a portion of each of the second hole H2 and the third hole H3 may have a curvature. For example, each of the second hole H2 and the third hole H3 may be defined as a circular planar shape. However, the present invention is not limited thereto, and the planar shape of each of the second and third holes H2 and H3 may be variously changed. As used herein, the "planar shape" is a shape in a plan view.

In an embodiment, a first width WD1 of the first hole H1 in the first direction DR1 may be smaller than a second width WD2 of each of the second hole H2 and the third hole H3 in the first direction DR1. Here, the second width WD2 may be a maximum width in the first direction DR1 in the planar shape of each of the second hole H2 and the third hole H3.

The first hole H1 may be formed by minimal laser processing. For example, the first hole H1 may be formed by single laser processing, and the first width WD1 may be defined as a width of a laser beam that may be formed by the single laser processing. For example, the first width WD1 may be greater than 0 millimeters (mm) and less than or equal to about 0.15 mm. However, the present invention is not limited thereto, and the first width WD1 may be changed depending on a laser that may be used for laser processing. For example, the second width WD2 may be greater than the first width WD1 in a range greater than 0 mm and less than or equal to about 0.9 mm. The shape of each of the first, second, and third holes H1, H2, and H3 (i.e., the shape of the through-holes HL) may be easily processed (or formed) by a laser, and accordingly, a processing time of the through-holes HL may be shortened.

A length LT of each of the through-holes HL in the second direction DR2 may be about 5 mm to about 14 mm. When the length LT is smaller than about 5 mm, reliability of the digitizer DGT1 may be degraded, such as when lines forming the first and second sensing coils RF and CF are disconnected. When the length LT is greater than about 14 mm, it may be difficult to configure a circuit of the digitizer DGT1. However, the present invention is not limited thereto, and as long as the reliability of the digitizer DGT1 is secured, the range of the length LT may be changed, such as when the length LT exceeds about 14 mm.

The through-holes HL may include a plurality of first through-holes HL1 and a plurality of second through-holes HL2. The first through-holes HL1 may be spaced apart from each other in the second direction DR2. The second through-holes HL2 may be spaced apart from the first through-holes HL1 in the first direction DR1. The second through-holes HL2 may be spaced apart from each other in the second direction DR2. The first through-holes HL1 and the second through-holes HL2 may be defined alternately in the first direction DR1.

The second through-holes HL2 may be shifted by a selected distance in the second direction DR2 from the first through-holes HL1. The first through-holes HL1 and the second through-holes HL2 may be defined in a zigzag manner along the first direction DR1. Accordingly, the folding portion FP of a remaining portion except for the through-holes HL may have a lattice-patterned slit shape.

A separation distance DS in the first direction DR1 between through-holes HL adjacent to each other in the first direction DR1 among the through-holes HL may be about 0.1 mm to about 1 mm. For example, a separation distance DS in the first direction DR1 between the first through-holes HL1 and the second through-holes HL2 adjacent to each other in the first direction DR1 may be about 0.1 mm to about 1 mm. In this case, the separation distance DS may be a distance in the first direction DR1 between the first hole H1 of each of the first through-holes HL1 and the first hole H1 of each of the second through-holes HL2.

For example, a separation distance in the second direction DR2 between the first through-holes HL1 and a separation distance in the second direction DR2 between the second through-holes HL2 may be substantially the same or similar to each other.

As each of the through-holes HL includes first, second, and third holes H1, H2, and H3, and the second width WD2 of the second and third holes H2 and H3 is formed to be greater than the first width WD1 of the first hole H1, when the folding portion FP of the digitizer DGT1 is folded, tearing of a portion between the through-holes HL (i.e., a portion having lattice-patterned slit shape) of the folding portion FP may be effectively prevented.

The first non-folding portion NFP1 and the second non-folding portion NFP2 may have substantially the same or symmetrical shape. Therefore, hereinafter, the following description will focus on the first non-folding portion NFP1. The description of the first non-folding portion NFP1 may replace the description of the second non-folding portion NFP2.

The first sensing coils RF may be disposed in the first non-folding portion NFP1 and the folding portion FP. In FIG. 9, coils RF1, RF2, RF3, RF4, RF5, and RF6 forming different loops among the first sensing coils RF are exemplarily illustrated. Each of the first sensing coils RF may extend through gaps between through-holes HL in the folding portion FP. In an embodiment, each of the first sensing coils RF may bend and extend along the edges of the through-holes HL in the folding portion FP.

In an embodiment, each of the first sensing coils RF may include a pattern portion PP in the folding portion FP. The pattern portion PP may include a first pattern P1, a second pattern P2, a third pattern P3, and a fourth pattern P4.

Each of the first pattern P1 and the second pattern P2 may extend in the second direction DR2. The first pattern P1 and the second pattern P2 may be spaced apart from each other in the first direction DR1, and a single through-hole HL may be disposed between the first pattern P1 and the second pattern P2. The first and second patterns P1 and P2 may surround at least a portion of the first hole H1 in a plan view.

The third pattern P3 may connect the first pattern P1 and the second pattern P2. In an embodiment, the third pattern P3 may have a curvature. The third pattern P3 may surround the second hole H2 or/and the third hole H3 in a plan view.

The fourth pattern P4 may extend from the second pattern P2 in the first direction DR1. The fourth pattern P4 may be connected to the first pattern P1 of another pattern portion PP included in the same first sensing coil RF. Accordingly, the pattern portion PP may be disposed between the through-holes HL.

As illustrated in FIG. 9, the first and second patterns P1 and P2 may have a linear shape extending in the second direction DR2, and the fourth pattern P4 may have a linear shape extending in the first direction DR1, but the present invention is not limited thereto. For example, each of the first, second, and fourth patterns P1, P2, and P4 may have a curvature like the third pattern P3.

The digitizer DGT1 according to an embodiment of the present invention may include the folding portion FP in which the through-holes HL are defined, and the first sensing coils RF extending along the edges of the through-holes HL. Each of the through-holes HL may be defined as the first, second, and third holes H1, H2, and H3, and the first width WD1 of the first hole H1 may be smaller than the second width WD2 of the second and third holes H2 and H3. Further, the through-holes HL may penetrate from an upper surface to a lower surface of the folding portion FP, and empty spaces may be formed in the through-holes HL. All the first to third holes H1 to H3 included in the through-hole HL may be also through-holes. Accordingly, when the display device DD is folded, the digitizer DGT1 may be easily folded. In addition, the shape of the through-holes HL may be easily processed by a laser. Accordingly, the processing time of the through-holes HL may be shortened, and efficiency of a manufacturing process of the digitizer DGT1 may be improved.

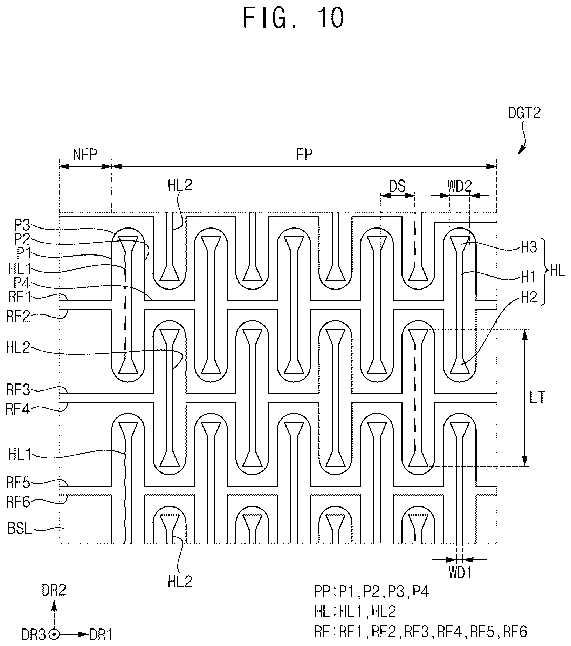

FIG. 10 is a plan view illustrating a digitizer according to an embodiment of the present invention.

A digitizer DGT2 described with reference to FIG. 10 may be substantially the same as or similar to the digitizer DGT1 described with reference to FIGS. 4, 5, 7, 8, and 9, except for the shape of the through-hole HL defined in the folding portion FP.

For example, FIG. 10 may be an enlarged plan view of a portion of a folding portion FP of the digitizer DGT2. FIG. 10 may correspond to the plan view of FIG. 9.

Hereinafter, descriptions overlapping with the digitizer DGT1 described with reference to FIGS. 4, 5, 7, 8, and 9 will be omitted or simplified.

Referring to FIG. 10, the digitizer DGT2 may include a non-folding portion NFP and the folding portion FP. The non-folding portion NFP may be a portion in which the digitizer DGT2 is not bent or folded, and the folding portion FP may be a portion in which the digitizer DGT2 is bent or folded. For example, a display device may include the digitizer DGT2, the non-folding portion NFP may at least partially overlap a non-folding area in which the display device is not bent or folded in a plan view, and the folding portion FP may at least partially overlap a folding area in which the display device is bent or folded in a plan view.

The non-folding portion NFP may include a first non-folding portion and a second non-folding portion spaced apart from each other, and the folding portion FP may be disposed between the first non-folding portion and the second non-folding portion. For example, the first non-folding portion may be adjacent to the folding portion FP in the direction opposite to the first direction DR1, and the second non-folding portion may be adjacent to the folding portion FP in the first direction DR1.

A plurality of through-holes HL may be defined in the folding portion FP. Each of the through-holes HL may penetrate the folding portion FP in the thickness direction (or the third direction DR3). Each of the through-holes HL may penetrate a base layer BSL forming a base of the digitizer DGT2 in a thickness direction (or the third direction DR3). In other words, the through-holes HL may communicate from an upper surface of the folding portion FP of the digitizer DGT2 to a lower surface of the folding portion FP of the digitizer DGT2. The inside of the through-holes HL may be empty spaces in which no other materials (e.g., resin) are disposed. The base layer BSL may include a material having a relatively low dielectric constant. For example, the base layer BSL may include a polyimide film, but the present invention is not limited thereto.

The through-holes HL may be spaced apart from each other in the first direction DR1. In addition, the through-holes HL may be spaced apart from each other in the second direction DR2. In an embodiment, the through-holes HL may be formed through laser processing.

As the digitizer DGT2 includes the folding portion FP, the digitizer DGT2 may secure flexibility during a folding operation, so that the shape thereof may be easily changed and may be easily folded.

Each of the through-holes HL may be defined as a first hole H1, a second hole H2, and a third hole H3 connected to each other. In an embodiment, the first hole H1 may extend in the second direction DR2, the second hole H2 may be defined at a first end of the first hole H1, and the third hole H3 may be defined at a second end facing (i.e., opposite to) the first end of the first hole H1. For example, the third hole H3 may be spaced apart from the second hole H2 in the second direction DR2, and the first hole H1 may connect the second hole H2 and the third hole H3 to each other.

A planar shape of the first hole H1 may be different from a planar shape of each of the second hole H2 and the third hole H3. For example, a planar shape of the second hole H2 and a planar shape of the third hole H3 may be symmetrical with respect to the first direction DR1. In an embodiment, each of the second hole H2 and the third hole H3 may be defined as a polygonal planar shape. For example, each of the second hole H2 and the third hole H3 may be defined as a triangular planar shape. However, the present invention is not limited thereto, and the planar shape of each of the second and third holes H2 and H3 may be variously changed.

In an embodiment, a first width WD1 of the first hole H1 in the first direction DR1 may be smaller than a second width WD2 of each of the second hole H2 and the third hole H3 in the first direction DR1. Here, the second width WD2 may be a maximum width in the first direction DR1 in the planar shape of each of the second hole H2 and the third hole H3.

The first hole H1 may be formed by minimal laser processing. For example, the first width WD1 may be greater than 0 mm and less than or equal to about 0.15 mm. However, the present invention is not limited thereto, and the first width WD1 may be changed depending on a laser that may be used for laser processing. For example, the second width WD2 may be greater than the first width WD1 in a range greater than 0 mm and less than or equal to about 0.9 mm. The shape of each of the first, second, and third holes H1, H2, and H3 (i.e., the shape of the through-holes HL) may be easily processed (or formed) by a laser, and accordingly, a processing time of the through-holes HL may be shortened.

A length LT of each of the through-holes HL in the second direction DR2 may be about 5 mm to about 14 mm. When the length LT is smaller than about 5 mm, reliability of the digitizer DGT2 may be degraded, such as when lines forming the sensing coils RF are disconnected. When the length LT is greater than about 14 mm, it may be difficult to configure a circuit of the digitizer DGT2. However, the present invention is not limited thereto, and as long as the reliability of the digitizer DGT2 is secured, the range of the length LT may be changed, such as when the length LT exceeds about 14 mm.

The through-holes HL may include a plurality of first through-holes HL1 and a plurality of second through-holes HL2. The first through-holes HL1 may be spaced apart from each other in the second direction DR2. The second through-holes HL2 may be spaced apart from the first through-holes HL1 in the first direction DR1. The second through-holes HL2 may be spaced apart from each other in the second direction DR2. The first through-holes HL1 and the second through-holes HL2 may be defined alternately in the first direction DR1.

The second through-holes HL2 may be shifted by a selected distance from the first through-holes HL1 in the second direction DR2. The first through-holes HL1 and the second through-holes HL2 may be defined in a zigzag manner along the first direction DR1. Accordingly, the folding portion FP of a remaining portion except for the through-holes HL may have a lattice-patterned slit shape.

A separation distance DS in the first direction DR1 between through-holes HL adjacent to each other in the first direction DR1 among the through-holes HL may be about 0.1 mm to about 1 mm. For example, a separation distance DS in the first direction DR1 between the first through-holes HL1 and the second through-holes HL2 adjacent to each other in the first direction DR1 may be about 0.1 mm to about 1 mm. In this case, the separation distance DS may be a distance in the first direction DR1 between the first hole H1 of each of the first through-holes HL1 and the first hole H1 of each of the second through-holes HL2. For example, a separation distance in the second direction DR2 between the first through-holes HL1 and a separation distance in the second direction DR2 between the second through-holes HL2 may be substantially the same as or similar to each other.

As each of the through-holes HL includes the first, second, and third holes H1, H2, and H3, and the second width WD2 of the second and third holes H2 and H3 is formed to be greater than the first width WD1 of the first hole H1, when the folding portion FP of the digitizer DGT2 is folded, tearing of a portion between the through-holes HL (i.e., a portion having lattice-patterned slit shape) of the folding portion FP may be effectively prevented.

The digitizer DGT2 may further include the sensing coils RF that bend and extend along at least a portion of edges of the through-holes HL in a plan view. The sensing coils RF may be disposed on the base layer BSL. The sensing coils RF may be disposed in the non-folding portion NFP and the folding portion FP. In FIG. 10, coils RF1, RF2, RF3, RF4, RF5, and RF6 forming different loops among the sensing coils RF are exemplarily illustrated.

Each of the sensing coils RF may extend between the through-holes HL in the folding portion FP. In an embodiment, each of the sensing coils RF may be bent and extended along the edges of the through-holes HL in the folding portion FP. Each of the sensing coils RF may include a pattern portion PP in the folding portion FP. The pattern portion PP may include a first pattern P1, a second pattern P2, a third pattern P3, and a fourth pattern P4.

Each of the first pattern P1 and the second pattern P2 may extend in the second direction DR2. The first pattern P1 and the second pattern P2 may be spaced apart from each other in the first direction DR1, and a single through-hole HL may be disposed between the first pattern P1 and the second pattern P2. The first and second patterns P1 and P2 may surround at least a portion of the first hole H1 in a plan view. The third pattern P3 may connect the first pattern P1 and the second pattern P2. In an embodiment, the third pattern P3 may have a curvature. The third pattern P3 may surround the second hole H2 and the third hole H3 in a plan view. The fourth pattern P4 may extend from the second pattern P2 in the first direction DR1. The fourth pattern P4 may be connected to the first pattern P1 of another pattern portion PP included in the same first sensing coil RF.

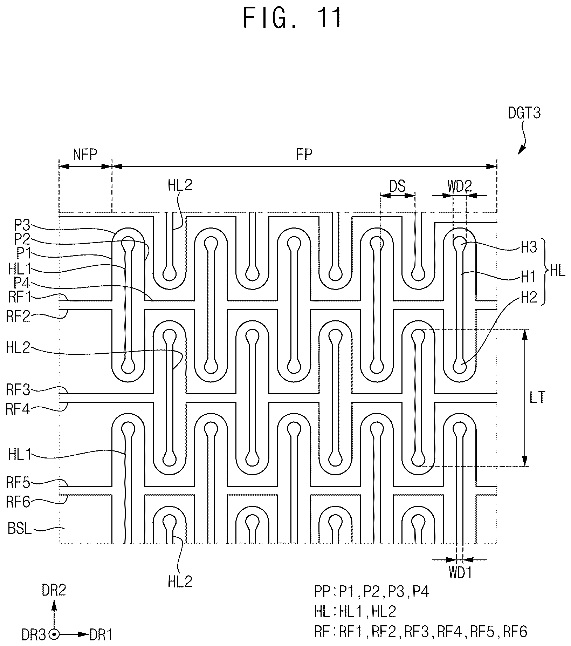

FIG. 11 is a plan view illustrating a digitizer according to an embodiment of the present invention.

A digitizer DGT3 described with reference to FIG. 11 may be substantially the same as or similar to the digitizer DGT1 described with reference to FIGS. 4, 5, 7, 8, and 9, except for the shape of the through-hole HL defined in the folding portion FP.

For example, FIG. 11 may be an enlarged plan view of a portion of a folding portion FP of the digitizer DGT3. FIG. 11 may correspond to the plan view of FIG. 9.

Hereinafter, descriptions overlapping the digitizer DGT1 described with reference to FIGS. 4, 5, 7, 8, and 9 will be omitted or simplified.

Referring to FIG. 11, the digitizer DGT3 may include a non-folding portion NFP and the folding portion FP. The non-folding portion NFP may be a portion in which the digitizer DGT3 is not bent or folded, and the folding portion FP may be a portion in which the digitizer DGT3 is bent or folded. For example, a display device may include the digitizer DGT3, the non-folding portion NFP may at least partially overlap a non-folding area in which the display device is not bent or folded in a plan view, and the folding portion FP may at least partially overlap a folding area in which the display device is bent or folded in a plan view.

The non-folding portion NFP may include a first non-folding portion and a second non-folding portion spaced apart from each other, and the folding portion FP may be disposed between the first non-folding portion and the second non-folding portion. For example, the first non-folding portion may be adjacent to the folding portion FP in the direction opposite to the first direction DR1, and the second non-folding portion may be adjacent to the folding portion FP in the first direction DR1.

A plurality of through-holes HL may be defined in the folding portion FP. Each of the through-holes HL may penetrate the folding portion FP in the thickness direction (or the third direction DR3). Each of the through-holes HL may penetrate a base layer BSL forming a base of the digitizer DGT3 in the thickness direction (or the third direction DR3). In other words, the through-holes HL may communicate from an upper surface of the folding portion FP of the digitizer DGT3 to a lower surface of the folding portion FP of the digitizer DGT3. The inside of the through-holes HL may be empty spaces in which no other materials (e.g., resin) are disposed. The base layer BSL may include a material having a relatively low dielectric constant. For example, the base layer BSL may include a polyimide film, but the present invention is not limited thereto.

The through-holes HL may be spaced apart from each other in the first direction DR1. In addition, the through-holes HL may be spaced apart from each other in the second direction DR2. In an embodiment, the through-holes HL may be formed through laser processing.

As the digitizer DGT3 includes the folding portion FP, the digitizer DGT3 may secure flexibility during a folding operation, so that the shape thereof may be easily changed and may be easily folded.

Each of the through-holes HL may be defined as a first hole H1, a second hole H2, and a third hole H3 connected to each other. In an embodiment, the first hole H1 may extend in the second direction DR2, the second hole H2 may be defined at a first end of the first hole H1, and the third hole H3 may be defined at a second end facing (i.e., opposite to) the first end of the first hole H1. For example, the third hole H3 may be spaced apart from the second hole H2 in the second direction DR2, and the first hole H1 may connect the second hole H2 and the third hole H3 to each other. All the first to third holes H1 to H3 included in the through-hole HL may be also through-holes.

A planar shape of the first hole H1 may be different from a planar shape of each of the second hole H2 and the third hole H3. For example, a planar shape of the second hole H2 and a planar shape of the third hole H3 may be symmetrical with respect to the first direction DR1. In an embodiment, at least a portion of each of the second hole H2 and the third hole H3 may have a curvature. For example, each of the second hole H2 and the third hole H3 may be defined as a water-droplet planar shape. However, the present invention is not limited thereto, and the planar shape of each of the second and third holes H2 and H3 may be variously changed.

In an embodiment, a first width WD1 of the first hole H1 in the first direction DR1 may be smaller than a second width WD2 of each of the second hole H2 and the third hole H3 in the first direction DR1. Here, the second width WD2 may be a maximum width in the first direction DR1 in the planar shape of each of the second hole H2 and the third hole H3.

The first hole H1 may be formed by minimal laser processing. For example, the first width WD1 may be greater than 0 mm and less than or equal to about 0.15 mm. However, the present invention is not limited thereto, and the first width WD1 may be changed depending on a laser that may be used for laser processing. For example, the second width WD2 may be greater than the first width WD1 in a range greater than 0 mm and less than or equal to about 0.9 mm. The shape of each of the first, second, and third holes H1, H2, and H3 (i.e., the shape of the through-holes HL) may be easily processed (or formed) by laser, and accordingly, a processing time of the through-holes HL may be shortened.

A length LT of each of the through-holes HL in the second direction DR2 may be about 5 mm to about 14 mm. When the length LT is less than about 5 mm, reliability of the digitizer DGT3 may be degraded, such as when lines forming sensing coils RF are disconnected. When the length LT is greater than about 14 mm, it may be difficult to configure a circuit of the digitizer DGT3. However, the present invention is not limited thereto, and as long as the reliability of the digitizer DGT3 is secured, the range of the length LT may be changed, such as when the length LT exceeds about 14 mm.

The through-holes HL may include a plurality of first through-holes HL1 and a plurality of second through-holes HL2. The first through-holes HL1 may be spaced apart from each other in the second direction DR2. The second through-holes HL2 may be spaced apart from the first through-holes HL1 in the first direction DR1. The second through-holes HL2 may be spaced apart from each other in the second direction DR2. The first through-holes HL1 and the second through-holes HL2 may be defined alternately in the first direction DR1.

The second through-holes HL2 may be shifted by a selected distance from the first through-holes HL1 in the second direction DR2. The first through-holes HL1 and the second through-holes HL2 may be defined in a zigzag manner along the first direction DR1. Accordingly, the folding portion FP of a remaining portion except for the through-holes HL may have a lattice-patterned slit shape.

A separation distance DS between through-holes HL adjacent to each other in the first direction DR1 among the through-holes HL may be about 0.1 mm to about 1 mm. For example, a separation distance DS in the first direction DR1 between the first through-holes HL1 and the second through-holes HL2 adjacent to each other in the first direction DR1 may be about 0.1 mm to about 1 mm. In this case, the separation distance DS may be a distance in the first direction DR1 between the first hole H1 of each of the first through-holes HL1 and the first hole H1 of each of the second through-holes HL2. For example, a separation distance in the second direction DR2 between the first through-holes HL1 and a separation distance in the second direction DR2 between the second through-holes HL2 may be substantially the same as or similar to each other.

As each of the through-holes HL includes the first, second, and third holes H1, H2, and H3, and the second width WD2 of the second and third holes H2 and H3 is formed to be greater than the first width WD1 of the first hole H1, when the folding portion FP of the digitizer DGT3 is folded, tearing of a portion between the through-holes HL (i.e., a portion having lattice-patterned slit shape) of the folding portion FP may be effectively prevented.

The digitizer DGT3 may further include the sensing coils RF that bend and extend along at least a portion of edges of the through-holes HL in a plan view. The sensing coils RF may be disposed on the base layer BSL. The sensing coils RF may be disposed on the non-folding portion NFP and the folding portion FP. In FIG. 11, coils RF1, RF2, RF3, RF4, RF5, and RF6 forming different loops among the sensing coils RF are exemplarily illustrated.

Each of the sensing coils RF may extend between the through-holes HL in the folding portion FP. In an embodiment, each of the sensing coils RF may be bent and extended along the edges of the through-holes HL in the folding portion FP. Each of the sensing coils RF may include a pattern portion PP in the folding portion FP. The pattern portion PP may include a first pattern P1, a second pattern P2, a third pattern P3, and a fourth pattern P4.

Each of the first pattern P1 and the second pattern P2 may extend in the second direction DR2. The first pattern P1 and the second pattern P2 may be spaced apart from each other in the first direction DR1, and a single through-hole HL may be disposed between the first pattern P1 and the second pattern P2. The first and second patterns P1 and P2 may surround at least a portion of the first hole H1 in a plan view. The third pattern P3 may connect the first pattern P1 and the second pattern P2. In an embodiment, the third pattern P3 may have a curvature. The third pattern P3 may surround the second hole H2 and the third hole H3 in a plan view. The fourth pattern P4 may extend from the second pattern P2 in the first direction DR1. The fourth pattern P4 may be connected to the first pattern P1 of another pattern portion PP included in the same first sensing coil RF.

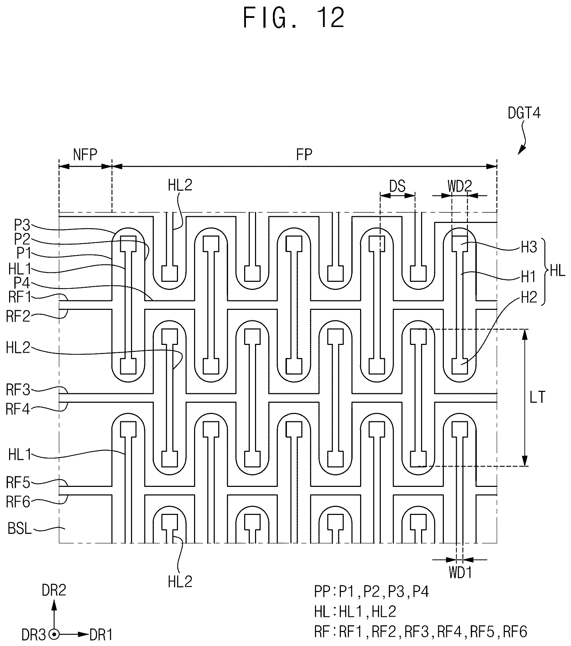

FIG. 12 is a plan view illustrating a digitizer according to an embodiment of the present invention.

A digitizer DGT4 described with reference to FIG. 12 may be substantially the same as or similar to the digitizer DGT1 described with reference to FIGS. 4, 5, 7, 8, and 9, except for the shape of the through-hole HL defined in the folding portion FP.

For example, FIG. 12 may be an enlarged plan view of a portion of a folding portion FP of the digitizer DGT4. FIG. 12 may correspond to the plan view of FIG. 9.

Hereinafter, descriptions overlapping with the digitizer DGT1 described with reference to FIGS. 4, 5, 7, 8, and 9 will be omitted or simplified.

Referring to FIG. 12, the digitizer DGT4 may include a non-folding portion NFP and the folding portion FP. The non-folding portion NFP may be a portion in which the digitizer DGT4 is not bent or folded, and the folding portion FP may be a portion in which the digitizer DGT4 is bent or folded. For example, a display device may include the digitizer DGT4, the non-folding portion NFP may at least partially overlap a non-folding area in which the display device is not bent or folded in a plan view, and the folding portion FP may at least partially overlap a folding area in which the display device is bent or folded in a plan view.

The non-folding portion NFP may include a first non-folding portion and a second non-folding portion spaced apart from each other, and the folding portion FP may be disposed between the first non-folding portion and the second non-folding portion. For example, the first non-folding portion may be adjacent to the folding portion FP in the direction opposite to the first direction DR1, and the second non-folding portion may be adjacent to the folding portion FP in the first direction DR1.

A plurality of through-holes HL may be defined in the folding portion FP. Each of the through-holes HL may penetrate the folding portion FP in the thickness direction (or the third direction DR3). Each of the through-holes HL may penetrate a base layer BSL forming a base of the digitizer DGT4 in the thickness direction (or the third direction DR3). In other words, the through-holes HL may communicate from an upper surface of the folding portion FP of the digitizer DGT4 to a lower surface of the folding portion FP of the digitizer DGT4. The inside of the through-holes HL may be empty spaces in which no other materials (e.g., resin) are disposed. The base layer BSL may include a material having a relatively low dielectric constant. For example, the base layer BSL may include a polyimide film, but the present invention is not limited thereto.

The through-holes HL may be spaced apart from each other in the first direction DR1. In addition, the through-holes HL may be spaced apart from each other in the second direction DR2. In an embodiment, the through-holes HL may be formed through laser processing.

As the digitizer DGT4 includes the folding portion FP, the digitizer DGT4 may secure flexibility during a folding operation, so that the shape thereof may be easily changed and may be easily folded.

Each of the through-holes HL may be defined as a first hole H1, a second hole H2, and a third hole H3 connected to each other. In an embodiment, the first hole H1 may extend in the second direction DR2, the second hole H2 may be defined at a first end of the first hole H1, and the third hole H3 may be defined at a second end facing (i.e., opposite to) the first end of the first hole H1. For example, the third hole H3 may be spaced apart from the second hole H2 in the second direction DR2, and the first hole H1 may connect the second hole H2 and the third hole H3 to each other.

A planar shape of the first hole H1 may be different from a planar shape of each of the second hole H2 and the third hole H3. For example, a planar shape of the second hole H2 and a planar shape of the third hole H3 may be substantially the same or similar. In an embodiment, each of the second hole H2 and the third hole H3 may be defined as a polygonal planar shape. For example, each of the second hole H2 and the third hole H3 may be defined as a rectangular planar shape. However, the present invention is not limited thereto, and the planar shape of each of the second and third holes H2 and H3 may be variously changed.

In an embodiment, a first width WD1 of the first hole H1 in the first direction DR1 may be smaller than a second width WD2 of each of the second hole H2 and the third hole H3 in the first direction DR1. Here, the second width WD2 may be a maximum width in the first direction DR1 in the planar shape of each of the second hole H2 and the third hole H3.

The first hole H1 may be formed by minimal laser processing. For example, the first width WD1 may be greater than 0 mm and less than or equal to about 0.15 mm. However, the present invention is not limited thereto, and the first width WD1 may be changed depending on a laser that may be used for laser processing. For example, the second width WD2 may be greater than the first width WD1 in a range greater than 0 mm and less than or equal to about 0.9 mm. The shape of each of the first, second, and third holes H1, H2, and H3 (i.e., the shape of the through-holes HL) may be easily processed (or formed) by a laser, and accordingly, a processing time of the through-holes HL may be shortened.

A length LT of each of the through-holes HL in the second direction DR2 may be about 5 mm to about 14 mm. When the length LT is smaller than about 5 mm, reliability of the digitizer DGT4 may be degraded, such as when lines forming sensing coils RF are disconnected. When the length LT is greater than about 14 mm, it may be difficult to configure a circuit of the digitizer DGT4. However, the present invention is not limited thereto, and as long as the reliability of the digitizer DGT4 is secured, the range of the length LT may be changed, such as when the length LT exceeds about 14 mm.

The through-holes HL may include a plurality of first through-holes HL1 and a plurality of second through-holes HL2. The first through-holes HL1 may be spaced apart from each other in the second direction DR2. The second through-holes HL2 may be spaced apart from the first through-holes HL1 in the first direction DR1. The second through-holes HL2 may be spaced apart from each other in the second direction DR2. The first through-holes HL1 and the second through-holes HL2 may be defined alternately in the first direction DR1.

The second through-holes HL2 may be shifted by a selected distance from the first through-holes HL1 in the second direction DR2. The first through-holes HL1 and the second through-holes HL2 may be defined in a zigzag manner along the first direction DR1. Accordingly, the folding portion FP of a remaining portion except for the through-holes HL may have a lattice-patterned slit shape.

A separation distance DS between through-holes HL adjacent to each other in the first direction DR1 among the through-holes HL may be about 0.1 mm to about 1 mm. For example, a separation distance DS in the first direction DR1 between the first through-holes HL1 and the second through-holes HL2 adjacent to each other in the first direction DR1 may be about 0.1 mm to about 1 mm. In this case, the separation distance DS may be a distance in the first direction DR1 between the first hole H1 of each of the first through-holes HL1 and the first hole H1 of each of the second through-holes HL2. For example, a separation distance in the second direction DR2 between the first through-holes HL1 and a separation distance in the second direction DR2 between the second through-holes HL2 may be substantially the same as or similar to each other.

As each of the through-holes HL includes the first, second, and third holes H1, H2, and H3, and the second width WD2 of the second and third holes H2 and H3 is formed to be greater than the first width WD1 of the first hole H1, when the folding portion FP of the digitizer DGT4 is folded, tearing of a portion between the through-holes HL (i.e., a portion having lattice-patterned slit shape) of the folding portion FP may be effectively prevented.

The digitizer DGT4 may further include the sensing coils RF that bend and extend along at least a portion of edges of the through-holes HL in a plan view. The sensing coils RF may be disposed on the base layer BSL. The sensing coils RF may be disposed on the non-folding portion NFP and the folding portion FP. In FIG. 12, coils RF1, RF2, RF3, RF4, RF5, and RF6 forming different loops among the sensing coils RF are exemplarily illustrated.

Each of the sensing coils RF may extend between the through-holes HL in the folding portion FP. In an embodiment, each of the sensing coils RF may be bent and extended along the edges of the through-holes HL in the folding portion FP. Each of the sensing coils RF may include a pattern portion PP in the folding portion FP. The pattern portion PP may include a first pattern P1, a second pattern P2, a third pattern P3, and a fourth pattern P4.

Each of the first pattern P1 and the second pattern P2 may extend in the second direction DR2. The first pattern P1 and the second pattern P2 may be spaced apart from each other in the first direction DR1, and a single through-hole HL may be disposed between the first pattern P1 and the second pattern P2. The first and second patterns P1 and P2 may surround at least a portion of the first hole H1 in a plan view. The third pattern P3 may connect the first pattern P1 and the second pattern P2. In an embodiment, the third pattern P3 may have a curvature. The third pattern P3 may surround the second hole H2 and the third hole H3 in a plan view. The fourth pattern P4 may extend from the second pattern P2 in the first direction DR1. The fourth pattern P4 may be connected to the first pattern P1 of another pattern portion PP included in the same first sensing coil RF.

The display device DD including the digitizer DGT1, DGT2, DGT3, or DGT4 according to an embodiment of the present invention may be applied to various electronic devices. An electronic device according to an embodiment of the present invention may include the display device DD described above, and may further include a module or device having other additional functions in addition to the display device DD.

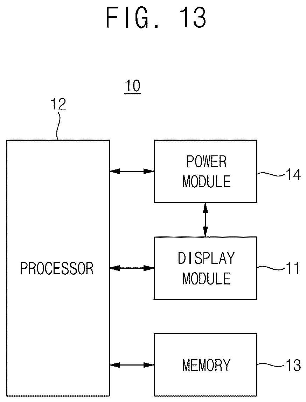

FIG. 13 is a block diagram illustrating an electronic device according to an embodiment of the present invention.

Referring to FIG. 13, an electronic device 10 may include a display module 11, a processor 12, a memory 13, and a power module 14.

The processor 12 may include at least one of a central processing unit (CPU), an application processor (AP), a graphic processing unit (GPU), a communication processor (CP), and an image signal processor (ISP).

The memory 13 may store data information necessary for operation of the processor 12 or the display module 11. When the processor 12 executes an application stored in the memory 13, an input image data signal and/or a control signal may be transmitted to the display module 11, and the display module 11 may process the received signal and output image information through a display screen.

The power module 14 may include a power supply module, such as a power adapter or a battery device, and a power conversion module that converts power supplied by the power supply module to generate power required for operation of the electronic device 10.

At least one of components of the electronic device 10 may be included in the display device according to embodiments of the present invention described above. In addition, some of individual modules functionally included in one module may be included in the display device, and other portions may be provided separately from the display device. For example, the display device may include the display module 11, and the processor 12, the memory 13, and the power module 14 may be provided in form of other devices within the electronic device 10 other than the display device.

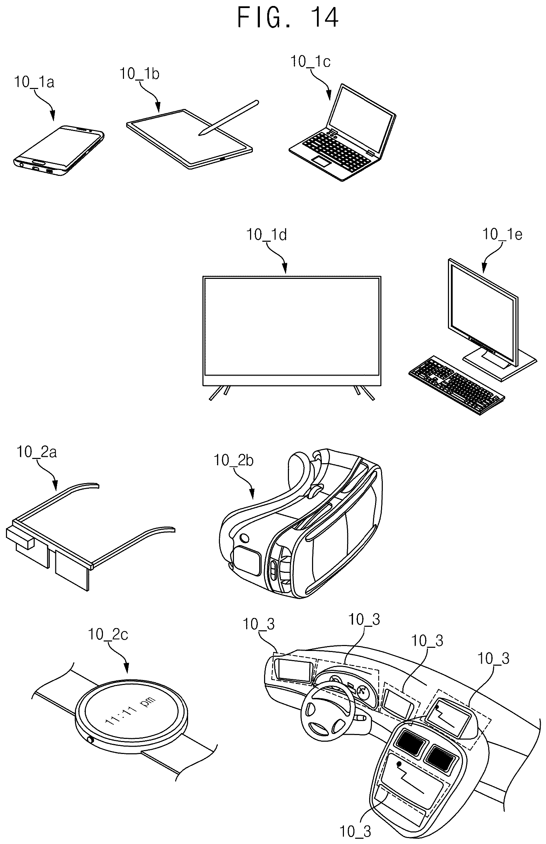

FIG. 14 is a schematic diagram illustrating electronic devices according to various embodiments of the present invention.

Referring to FIG. 14, various electronic devices to which the display device according to an embodiment of the present invention is applied may include not only image display electronic devices such as a smartphone 10_1a, a tablet PC 10_1b, a laptop 10_1c, a TV 10_1d, and a desktop monitor 10_1e, but also wearable electronic devices including display modules, such as smart glasses 10_2a, a head-mounted display 10_2b, and a smart watch 10_2c, automotive electronic devices 10_3 including display modules, such as a Center Information Display (CID) arranged on a cluster, a center fascia, and dashboard of a car, and a room mirror display, or the like.

The present invention can be applied to various display devices and electronic devices. For example, the present invention is applicable to various display devices such as display devices for vehicles, ships and aircraft, portable communication devices, display devices for exhibition or information transmission, medical display devices, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the present invention. Accordingly, all such modifications are intended to be included within the scope of the present invention as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A digitizer (DGT1-DGT4) comprising:
a base layer (BSL) including a folding portion (FP) in which through-holes (HL) are defined and a non-folding portion (NFP1, NFP2) adjacent to the folding portion (FP) in a first direction (DR1); and
sensing coils (RF, CF) disposed on the base layer (BSL),
wherein each of the through-holes (HL) is defined as:
a first hole (H1) extending in a second direction (DR2) intersecting the first direction (DR1);
a second hole (H2) defined at a first end of the first hole (H1); and
a third hole (H3) defined at a second end of the first hole (H1) opposite to the first end,
wherein a first width (WD1) of the first hole (H1) in the first direction (DR1) is smaller than a second width (WD2) of each of the second hole (H2) and the third hole (H3) in the first direction (DR1).

2. The digitizer (DGT1) of claim 1, wherein each of the second hole (H2) and the third hole (H3) has a circular planar shape.

3. The digitizer (DGT3) of claim 1, wherein each of the second hole (H2) and the third hole (H3) has a water-droplet planar shape.

4. The digitizer (DGT2, DGT4) of claim 1, wherein each of the second hole (H2) and the third hole (H3) has a polygonal planar shape.

5. The digitizer (DGT1-DGT4) of at least one of claims 1 to 4, wherein the second hole (H2) and the third hole (H3) have a same planar shape.

6. The digitizer (DGT1-DGT4) of at least one of claims 1 to 5, wherein the base layer (BSL) includes a polyimide film.

7. The digitizer (DGT1-DGT4) of at least one of claims 1 to 6, wherein the first width (WD1) of the first hole (H1) in the first direction (DR1) is greater than 0 mm and less than or equal to 0.15 mm.

8. The digitizer (DGT1-DGT4) of at least one of claims 1 to 7, wherein the second width (WD2) of each of the second hole (H2) and the third hole (H3) in the first direction (DR1) is greater than 0 mm and less than or equal to 0.9 mm.

9. The digitizer (DGT1-DGT4) of at least one of claims 1 to 8, wherein a separation distance (DS) between through-holes (HL) adjacent to each other in the first direction (DR1) among the through-holes (HL) is 0.1 mm to 1 mm.

10. The digitizer (DGT1-DGT4) of at least one of claims 1 to 9, wherein a length (LT) of each of the through-holes (HL) in the second direction (DR2) is 5 mm to 14 mm.

11. A display device (DD) comprising:
a display panel (DP); and
a digitizer (DGT1-DGT4) according to at least one of claims 1 to 10 disposed below the display panel (DP).

12. An electronic device (10) comprising:
a display device (DD) according to claim 11; and
a power module (14), which supplies power to the display device (DD).
